# EUROPEAN PATENT SPECIFICATION

(11) **EP 2 473 356 B1**
(45) Date of publication and mention of the grant of the patent: **18.07.2018**
(21) Application number: 10747867.9
(22) Date of filing: 02.09.2010
(51) Int. Cl.: H01L 31/18, B41M 3/14, B41M 3/00, H05K 3/12

(54) **MULTIPLE CONTROL METHOD FOR PRINTING A MULTILAYER PATTERN AND RELATIVE PLANT**
MEHRFACHES STEUERUNGSVERFAHREN ZUM DRUCKEN EINER MEHRSCHICHTIGEN STRUKTUR UND ZUGEHÖRIGE ANLAGE
PROCÉDÉ DE COMMANDE MULTIPLE POUR L'IMPRESSION D'UN MOTIF MULTICOUCHE ET INSTALLATION AFFÉRENTE

(30) Priority: 03.09.2009 IT UD20090149
(43) Date of publication of application: 11.07.2012
(73) Proprietor: Applied Materials, Inc., Santa Clara, CA 95054 (US)
(72) Inventor: GALIAZZO, Marco, I-35127 Padova (IT); BACCINI, Andrea, 31030 Mignagola di Carbonera (IT); CELLERE, Giorgio, I-36040 Torri Di Quartesolo (IT); DE SANTI, Luigi, I-31027 Spresiano (IT); PASQUALIN, Gianfranco, I-31027 Spresiano (IT); VERCESI, Tommaso, I-31057 Silea (IT)
(74) Representative: Zimmermann & Partner Patentanwälte mbB
(86) International application number: PCT/EP2010/062848
(87) International publication number: WO 2011/026884

(56) References cited:
- EP-A1- 0 906 827
- US-A1- 2005 122 351
- SZLUFCIK J ET AL: "High-efficiency low-cost integral screen-printing multicrystalline silicon solar cells", SOLAR ENERGY MATERIALS AND SOLAR CELLS, ELSEVIER SCIENCE PUBLISHERS, AMSTERDAM, NL LNKD- DOI:10.1016/S0927-0248(02)00060-0, vol. 74, no. 1-4, 1 October 2002 (2002-10-01), pages 155-163, XP004376938, ISSN: 0927-0248

## Description

### FIELD OF THE INVENTION

The present invention concerns a control method for printing a multi-layer pattern on a substrate or support, and a system adapted to perform the control method.

A typical application is used to process substrates, for example, made from silicon or alumina, which can be used to form a photovoltaic cell or a green-tape type circuit device.

In particular, the method can be used in a system for producing multi-layer patterns by means of multi-layer printing on a substrate, whether it be by silk-screen printing, ink-jet printing, laser printing or other type of printing.

### BACKGROUND OF THE INVENTION

Methods are known for the production of multi-layer patterns by means of several successive printing steps, for example silk-screen printing, laser, ink jet or other similar processes, on a suitable support or substrate, for example a wafer with a silicon or alumina base.

The multi-layer structures provide a means to increase the current delivered from the contacts, but make the printing process more complex since one needs to assure that the various layers are correctly aligned with each other. Typically, if the movement of the substrate on an automated transfer device, and the movement of a printing head are not well controlled the deposited pattern will be improperly formed.

These known methods have a disadvantage in that the lack of uniformity of the deposited layers on the processed substrate can only be detected downstream of the printing process, which will cause the misprocessed substrate(s) and possibly all other substrate(s) processed in the line within the same batch to be scrapped.

Therefore there is a need for one or more control steps after each printing step.

Using conventional processing techniques it is not possible to reset the, or to re-align, the system or substrates after an issue is found with the printing process without stopping the whole system, and thus reducing the substrate throughput.

Furthermore, if an error occurs during a printing process step, such as misalignments of the multiple printed layers will cause the substrate to be discarded.

Embodiments of the present invention thus provide a method of printing multiple layers on a substrate, which allows each individual printing step to be controlled irrespective of the previous printing steps, and that allows the correct adjustment of all the printing stations and/or the correct alignment of the substrate without stopping the system.

US 2005/122351 A1 (YAMAZAKI SHUNPEI [JP] ET AL) 9 June 2005 (2005-06-09) is a prior art teaching relevant to the present invention.

The Applicant has devised, tested and embodied the present invention to overcome the shortcomings of the state of the art and to obtain these and other purposes and advantages.

### SUMMARY OF THE INVENTION

The present invention is set forth and characterized in the independent claims, while the dependent claims describe other characteristics of the invention or variants to the main inventive idea.

In accordance with the above purpose, a method for multi-layer printing, for example silk-screen printing, laser, ink jet or the like, on a surface of a substrate, comprises a plurality of printing steps comprising a first printing step and further subsequent printing steps carried out in sequence in various printing stations. In one case, the substrate may comprise silicon or alumina or other similar material.

The method according to the present invention also provides a plurality of alignment steps, each provided upstream of a corresponding of said further subsequent printing steps after the first printing step, in which alignment devices perform the positioning of the substrate and/or the adjustment of the printing station in order to print a subsequent layer on the substrate.

According to a characteristic feature of the present invention, downstream of each printing step and upstream of each subsequent alignment step, which are used to align the substrate, the method comprises a control step in which detection device detects the position of the layer printed on the support and/or the position of said support on a work plane, and in which at least a command and control unit compares said positions detected with predefined positions and/or with the positions detected at least in a previous control step and in which the results of said comparison are used in the alignment step.

### BRIEF DESCRIPTION OF THE DRAWINGS

So that the manner in which the above recited features of the present invention can be understood in detail, a more particular description of the invention, briefly summarized above, may be had by reference to embodiments, some of which are illustrated in the appended drawings. It is to be noted, however, that the appended drawings illustrate only typical embodiments of this invention and are therefore not to be considered limiting of its scope, for the invention may admit to other equally effective embodiments.
Figure 1 shows a flow chart of a multi-layer printing process according to the present invention;
Figure 2 is a schematic view of a plant for the multi-layer printing process according to the present invention;
Figure 3 is a schematic view of a variant of the plant in Figure 2;
Figure 4 is plan view of a surface of a substrate that has a heavily doped region and a patterned metal contact structure formed thereon according to one embodiment of the invention;
Figure 5 is a close-up side cross-sectional view of a portion of the surface of the substrate shown in Figure 4 according to one embodiment of the invention;
Figure 5a is a close-up side cross-sectional view of a portion of the surface of the substrate shown in Figure 4 according to a further embodiment of the invention;
Figure 6 is a schematic isometric view of a system that may be used in conjunction with embodiments of the present invention;
Figure 7 is a schematic top plan view of the system in Figure 6 according to one embodiment of the invention;
Figure 8 is an isometric view of a printing nest portion of the screen printing system according to one embodiment of the invention;
Figure 9 is a schematic isometric view of one embodiment of a rotary actuator assembly having an inspection assembly is positioned to inspect the front surface of the substrate according to one embodiment of the invention;
Figure 10 is a schematic cross-sectional view of a optical inspection system according to one embodiment of the invention
Figure 11 is a schematic cross-sectional view of a optical inspection system positioned in a printing nest according to one embodiment of the invention.

To facilitate understanding, identical reference numerals have been used, where possible, to designate identical elements that are common to the figures. It is contemplated that elements and features of one embodiment may be beneficially incorporated in other embodiments without further recitation.

### DETAILED DESCRIPTION OF A PREFERENTIAL FORM OF EMBODIMENT

A method according to the present invention is used to perform a multi-layer silk-screen printing process on a surface of a substrate.

The method according to the invention provides to effect at least a first print step on the substrate, a subsequent alignment step of the substrate, propaedeutic for a second or subsequent print step, and at least a second print step on the substrate and to read accuracy of the alignment after the second print step. This datum can be fed back to the previous alignment step and, in general to all previous alignment blocks, in order to improve accuracy.

With the present invention, it is always possible to form, without interrupting the processes performed in a system, a printed layer that is aligned with the printed layer formed immediately before it, but also with all the other printed layers printed before it.

Indeed, control steps, carried out after the first printing step, are used to detect whether the printed layer is consistent, or not, with respect to all the previous printing steps.

Furthermore, it is in the spirit of the present invention to use the positions detected in each control step in subsequent alignment steps, typically found prior to said control step.

This solution allows one to optimize the printing processes on subsequent supports without needing to stop the system to adjust the printing process settings.

According to a variant, each control step is performed in a command and control station connected to a printing station. In another variant, multiple pairs of command and control stations and printing stations are connected together to form a processing line.

According to another variant, all of the command and control stations in a processing line supply the data detected to a central control and data processing unit which organizes and stores the data collected in a data base so that the data can be provided in a desired way requested by the user. In this way it is possible to identify possible critical points in the production processes, to keep a history of the work carried out and to process desired statistics.

According to another variant, in each control step the data regarding the position of the printed layer are detected by detection devices located downstream of each printing station and are transmitted to a sole command and control unit that processes the received data, compares the collected data according to preset programs, and transmits the control signals to the different printing stations.

Embodiments of the method according to the invention comprise three successive printing steps indicated respectively by the numbers 11, 21 and 31.

Embodiments of the method according to the invention comprise three control steps 12, 22, 32, two alignment steps 13, 23 and a discharge step 40, described in more detail hereafter.

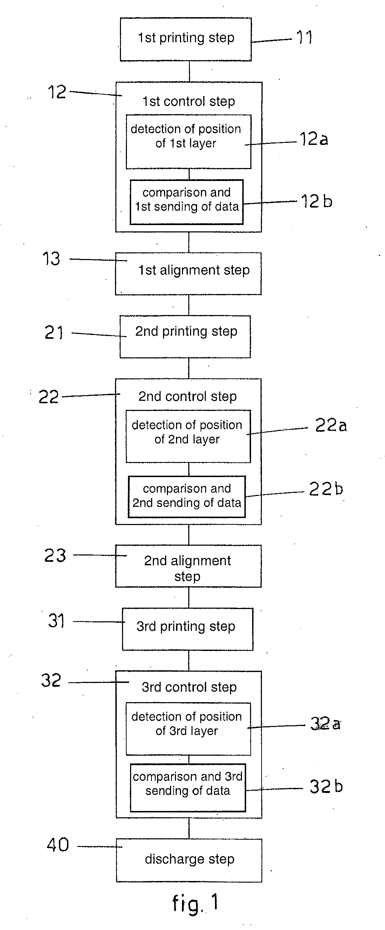

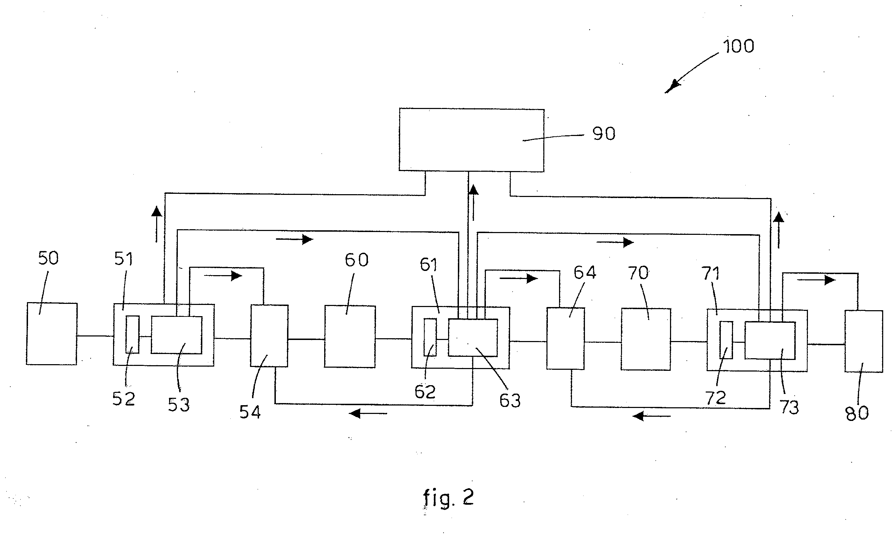

Figure 2 shows schematically a possible embodiment of a system 100 that is able to carry out the method shown in Fig. 1. The system 100 may comprise, in succession, a first printing station 50, a first control station 51, first alignment devices 54, a second printing station 60, a second control station 61, second alignment devices 64, a third printing station 70, a third control station 71, a discharge station 80 and a central control and data processing unit 90.

In one embodiment, each control station 51, 61, 71 comprise detection devices 52, 62, 72 and a command and control unit 53, 63, 73, respectively.

According to the present invention, in the first printing step 11 the silk-screen printing is carried out on a surface of a substrate, for example a silicon based wafer, to form a first layer of a multilayer pattern, in correspondence with the first printing station 50 in which the substrate is fed by means of known feed systems.

Downstream of the first printing step 11, the method according to the present invention provides a first control step 12 comprising a first detection sub-step 12a in which the first detection devices 52, for example of the optical type, detect the position of the first layer printed on the substrate and the position of the substrate itself on the work plane, for example a printing nest as described below, and a comparison and first data transmission sub-step 12b. In this sub-step the first command and control unit 53 compares the positions detected with preprogrammed positions and subsequently sends the detected and processed data to the first alignment devices 54 and to the second command and control unit 63.

The first control step 12 is followed by a first alignment step 13 in which, in relation to the position of the first printed layer, the first alignment devices 54, for example thrusters, position the substrate correctly for the execution of the second printing step 21.

In another form of embodiment, the correct positioning of the substrate is achieved by aligning a device for moving the substrate below the printing heads present in the second printing station.

The first alignment devices 54 can also provide actuators for positioning the printing heads present in the second printing station 60.

After the second printing step 21, in which a second layer of the pattern is printed on the substrate, the present invention provides a second control step 22, comprising a second detection sub-step, in which the second detection devices 62 detect the position of the second printed layer, and a comparison and second data transmission sub-step in which the data detected are compared with predefined data and with the data received from the first command and control unit 53.

In the event that said data are not consistent, the second command and control unit 63 sends a feed-back signal to the first alignment devices 54 to communicate the non-consistency.

In both cases, whether the data arriving from the first command and control unit 53 and the data detected by the second detection devices 62 are consistent or not, the second control step 22 also provides that the second command and control unit 63 sends the data detected to the first alignment devices 54 and to the third command and control unit 73.

In a second alignment step 23, the second alignment devices 64 position the substrate correctly for the execution of the third printing step 31.

After the second alignment step, the third printing step 31 and a third control step 32 are carried out.

In particular, in the third printing step 31, in correspondence with the third printing station 70, a third layer of the pattern is printed, in the third control step 32, divided into a detection sub-step and a comparison and third data transmission sub-step, the position of the third printed layer is detected and compared with the data received from the second command and control unit 63.

In exactly the same way as the second control step 22, the third command and control unit 73, if the data received from the second command and control unit 63 and those detected are not consistent, sends a feed-back signal to the second alignment devices 64.

Furthermore, if the data detected and the data programmed are not consistent, the third command and control unit 73 sends a signal to the discharge station 40 which, in the discharge step, discharges from the system the substrates produced either toward the final store or toward the discards store.

A second work cycle begins with feeding a second substrate to the first printing station when the first substrate has left it and has been moved so that the first control step 12 can be carried out.

When the first substrate is subjected to the second printing step 21, the first control step 12 and the first alignment step 13 relating to the second substrate are carried out.

During the first alignment step 13, the first alignment devices 54 act both according to the data arriving from the first command and control unit 53, and relating to the second substrate after the first printing step 11, and also according to any data arriving from the second command and control unit 63, and relating to the position of the first substrate following the second printing step 21, in order to initiate the relative corrective actions, for example by moving the substrate or correcting subsequent substrate's position by use of the alignment device or actuator, on the alignment of the second substrate.

In this way, the first alignment step 13 performed on the second substrate compensates possible defects in the positioning of the second substrate after the first printing step 11, and also possible intrinsic defects of the second printing station 60, for example in the particular case of a silk-screen printing head, defects of the net.

In the same way, during the second alignment step 23 of the second substrate, the second alignment devices 64 act both according to the data arriving from the second command and control unit 63, and relating to the second substrate after the second printing step 21, and also according to any data arriving from the third control unit 73, and relating to the position of the first substrate following the third printing step 31, in order to initiate the relative corrective actions on the alignment of the second substrate.

The same method is used to produce the multi-layer pattern on subsequent substrates.

Each command and control unit 53, 63, 73 also supplies the data detected to the central control and data processing unit 90 which organizes, memorizes the data collected according to data bases predefined by the user, and processes them in the forms and ways requested by the user, for example statistically, or in such a manner as to identify the critical points of the production process.

In Figure 2, the arrows indicate the directions of the data flows between the various parts of the system 100.

According to a variant, the present invention can be used to make patterns with more than three layers.

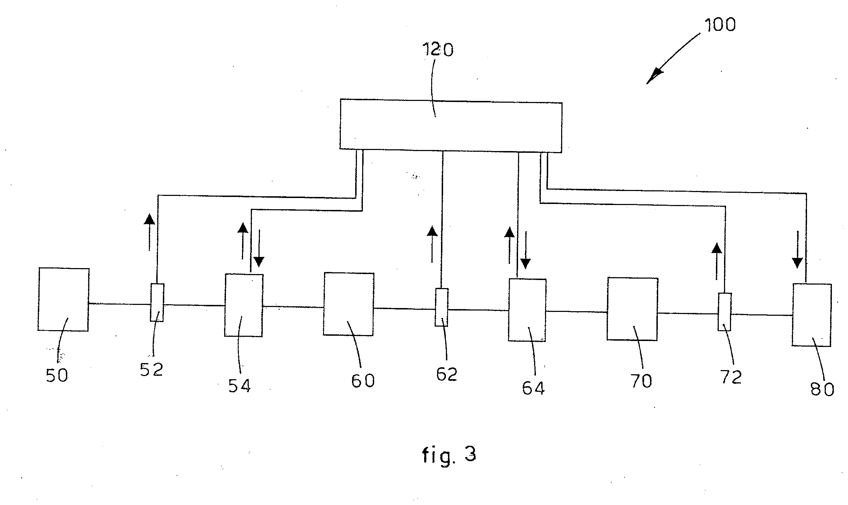

According to a further variant, shown in Figure 3, all the data transmission sub-steps can be governed by a single central command and control unit 120 that processes the data arriving from the detection devices 52, 62, 72 downstream of each printing station 50, 60, 70, compares them according to preset programs and transmits the control signals to the different alignment devices 54, 64.

It is clear that also the control units 90 and 120 as referred above can be, in general, configured as the above-mentioned control units 53, 63, 73.

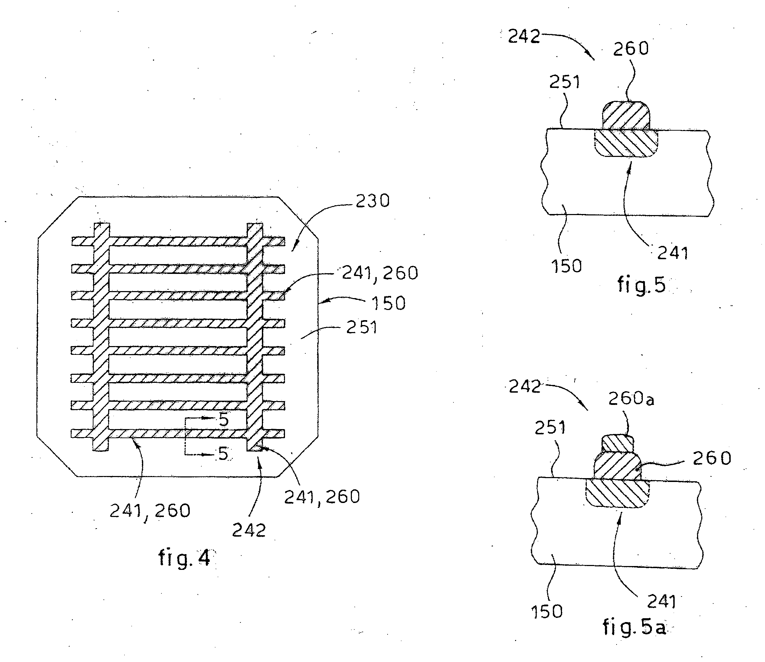

Embodiments of the invention, related to the more general printing steps 11, 21, 31 described above, specifically apply to a solar cell formation process that includes the formation of metal contacts over heavily doped regions 241 that are formed in a desired pattern 230 on a surface of a substrate 250 (Figures 4 and 5).

Embodiments of the invention provides that in the first printing step 11 a dopant paste is printed to determine the heavily doped regions 241, in the second printing step 12 a wide metal line defining wide fingers 260 is printed on the heavily doped regions 241 and in the third printing step 13 a narrow metal line defining narrow fingers 260a is printed on the wide metal line (see Figures 5 and 5A).

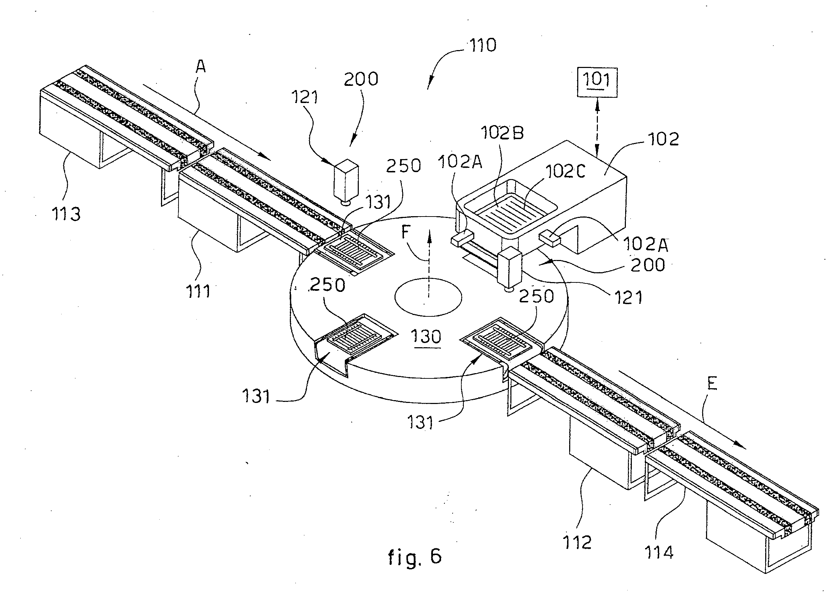

According to embodiments of the invention, as will be more precisely described below, one or more, or each, of the above-mentioned printing stations 50, 60, 70 can be configured as a printing system 110 described in connection with Figures 6-9.

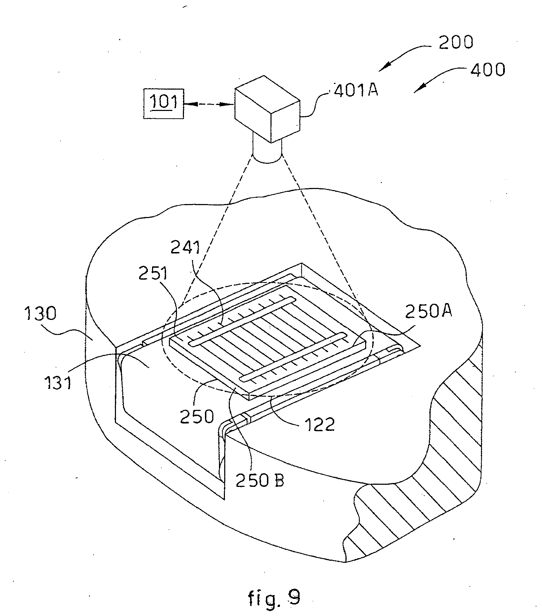

Moreover, the above-mentioned control station 51, 61, 71, that are provided with detection device 52, 62 72 and control units 53, 63, 73, can be configured as an inspection system 400 described below in connection with Figures 9-11 associated with the system controller 101 exemplified in Figures 6, 7, 9 - 11. In particular, control units 53, 63, 73 can be configured as the system controller 101 described hereinafter.

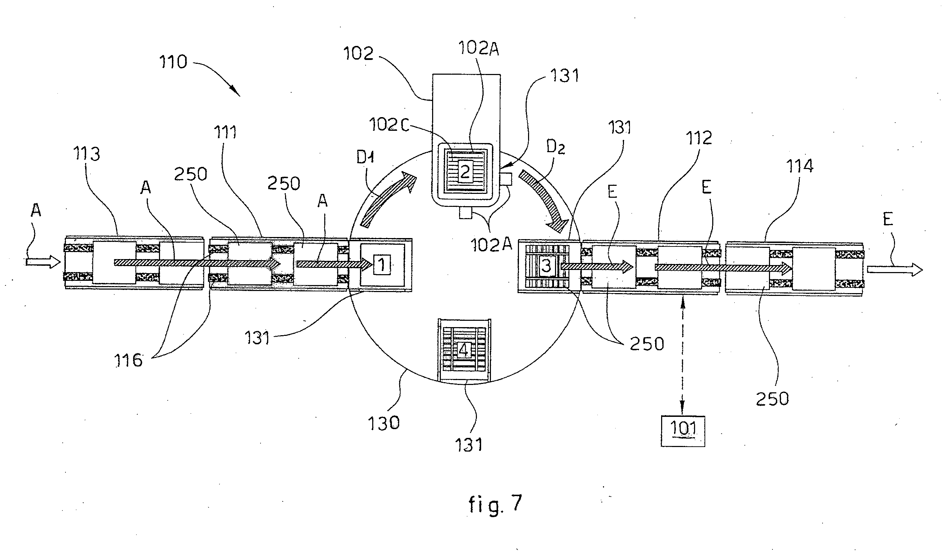

Furthermore, the above-mentioned alignment device 54, 64 can be configured as actuators 102A described below in connection with printing chamber 102 of Figures 6 and 7.

Embodiments of the invention, related to the more general control steps 12, 22, 32 and alignment steps 12, 23, 33 described above, specifically also provide an inspection system and supporting hardware that is used to reliably position a similarly shaped, or patterned, metal contact structure on the patterned heavily doped regions to allow an Ohmic contact to be made.

Figure 4 is plan view of a surface 251 of the substrate 250 that has a heavily doped region 241 and a patterned metal contact structure 242 formed thereon, such as the fingers 260. Figure 5 is side cross-sectional view created at the cross-section line 5-5 shown in Figure 2A, and illustrates a portion of the surface 251 having a metal finger 260 disposed on the heavily doped region 241. The metal contact structure, such as fingers 260 and busbars, are formed on the heavily doped regions 241 so that a high quality electrical connection can be formed between these two regions. Low-resistance, stable contacts are critical for the performance of the solar cell. The heavily doped regions 241 generally comprise a portion of the substrate 250 material that has about 0.1 atomic % or less of dopant atoms disposed therein. A patterned type of heavily doped regions 241 can be formed by conventional lithographic and ion implantation techniques, or conventional dielectric masking and high temperature furnace diffusion techniques that are well known in the art. However, the processes of aligning and depositing the metal contact structure 242 on the heavily doped regions 241 is generally not possible using conventional techniques, since there is typically no way to optically determine the actual alignment and orientation of the formed heavily doped region 241 pattern on the surface 251 of the substrate 250 using these techniques.

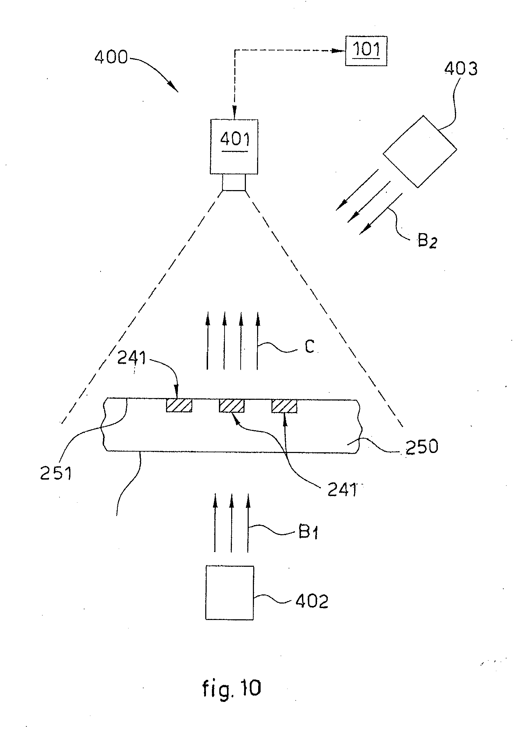

Embodiments of the invention thus provide a first detection of the actual alignment and orientation of the patterned heavily doped regions 241, printed in the first printing step 21, corresponding to the first control step 12 and in particular to the first detection sub-step 12a, and then forming patterned metal contacts on the surface of the heavily doped regions 241 using the collected information (second printing step 21). Figure 10 illustrates one embodiment of an optical inspection system 400 that can be used as the above-mentioned more general first detection device 52 and is, thus, configured to determine the actual alignment and orientation of the pattern 230 of the heavily doped region(s) 241 formed on a surface of a substrate 250. The optical inspection system 400 generally contains one or more electromagnetic radiation sources, such as radiation sources 402 and 403 that are configured to emit radiation at a desired wavelength and a detector assembly 401 this configured to capture the reflected or un-absorbed radiation so that the alignment and orientation of the heavily doped regions 241 can be optically determined relative to the other non-heavily doped regions of the substrate 250. The orientation and alignment data collected by the detector assembly 401 is then delivered to a system controller 101 that is configured to operate the above-mentioned first alignment step 13 to adjust and control the placement alignment of the substrate for the purpose of the second printing step 21 the metal contact structure, such as fingers 260, on the surfaced of the heavily doped regions 241 by use of patterned metallization technique. Patterned metallization techniques may include screen printing processes, ink jet printing processes, lithographic and blanket metal deposition process, or other similar patterned metallization processes. In one embodiment, the metal contacts are disposed on the surface of the substrate 250 using a screen printing process performed in a screen printing system 100, as discussed below in conjunction with Figures 6-9.

In configurations where the heavily doped regions 241 are formed within a silicon substrate it is believed that electromagnetic radiation emitted at wavelengths within the ultraviolet (UV) and infrared (IR) wavelength regions will either be preferentially absorbed, reflected or transmitted by the silicon substrate or heavily doped regions. The difference in the transmission, absorption or reflection of the emitted radiation can thus be used to create some discernable contrast that can be resolved by the detector assembly 401 and system controller 101. In one embodiment, it is desirable to emit electromagnetic radiation at wavelengths between about 850 nm and 4 microns (µm). In one embodiment, one or more of the radiation sources 402 and 403 are light emitting diodes (LEDs) that are adapted to deliver on or more of the desired wavelengths of light.

In one embodiment, the optical inspection system 400 has a radiation source 402 that is configured to deliver electromagnetic radiation "B1" to a surface 252 of a substrate 250 that is opposite to the side of the substrate on which the detector assembly 401 is disposed. In one example, the radiation source 402 is disposed adjacent to the backside of a solar cell substrate 250 and the detector assembly 401 is disposed adjacent to the front surface of the substrate 250. In this configuration, it is desirable to use optical radiation greater than the absorption edge of silicon, such as greater than 1060 nm to allow that emitted electromagnetic radiation "B1" to pass through the substrate 250 and be delivered to the detector assembly 401 following path "C". It is believed that due to the high doping level (e.g., >10¹⁸ atoms/cm³) in the heavily doped regions versus the typically lightly doped silicon substrate (e.g., <10¹⁷ atoms/cm³), typically used in solar cell applications, the absorption or transmissive properties will be significantly different for each of these regions within these wavelengths. In one embodiment, it is desirable to confine the emitted wavelengths in a range between about 1.1 µm and about 1.5 µm. In one example, the heavily doped regions have a resistivity of at least 50 Ohms per square.

In another embodiment of the optical inspection system 400, a radiation source 403 is configured to deliver electromagnetic radiation "B2" to a surface 251 of a substrate 250 that is on the same side of the substrate as the detector assembly 401 so that one or more of the emitted wavelengths will be absorbed or reflected by portions of the substrate 250 or the heavily doped regions 241 and delivered to the camera following path "C". In this configuration, it is desirable to emit optical radiation at wavelengths between about 850 nm and 4 microns (µm) until a desired contrast between the regions can be detected by the detector assembly 401.

In one embodiment of the optical inspection system 400, two radiation sources 402 and 403 and one or more detector assemblies 401 are used to help further detect the pattern of the heavily doped regions 241 on the surface of the substrate 250. In this case, it may be desirable to configure the radiation sources 402 and 403 so that they emit radiation at the same or different wavelengths.

The detector assembly 401 includes an electromagnetic radiation detector, camera or other similar device that is configured to measure the intensity of the received electromagnetic radiation at one or more wavelengths. In one embodiment, the detector assembly 401 includes a camera 401A that is configured to detect and resolve features on a surface of a substrate within a desired wavelength range emitted by one or more of the radiation sources 402 or 403. In one embodiment, the camera 401A is an InGaAs type camera that has a cooled CCD array to enhance the signal-to-noise ratio of the detect signal. In some configurations, it is desirable to isolate the detector assembly 401 from ambient light by enclosing or shielding the areas between the surface 251 of the substrate 250 and the camera 401A.

In one embodiment, the detector assembly 401 also includes one or more optical filters (not shown) that are disposed between the camera 401A and the surface of the substrate 251. In this configuration, the optical filter(s) are selected to allow only certain desired wavelengths to pass to the camera 401A to reduce the amount of unwanted energy being received by the camera 401A to improve the signal-to-noise ratio of the detected radiation. The optical filter(s) can be a bandpass filter, a narrowband filter, an optical edge filters, a notch filter, or a wideband filter purchased from, for example, Barr Associates, Inc. or Andover Corporation. In another aspect of the invention, an optical filter is added between the radiation sources 402 or 403 and the substrate 250 to limit the wavelengths projected onto the substrate and detected by the camera 401A. In this configuration, it may be desirable to select radiation sources 402 or 403 that can deliver a broad range of wavelengths and use filters to limit the wavelengths that strike the surface of the substrate.

According to a further aspect of the invention, Figure 6 is a schematic isometric view and Figure 7 is a schematic top plan view illustrating one embodiment of a screen printing system 110, that may be used as one or more of the printing stations 50, 60, 70 of the system 100 of Figure 2 or 3, also in conjunction with embodiments of the present invention to form the metal contacts in a desired pattern on a surface of a solar cell substrate 250 using the optical inspection system 400. In one embodiment, the screen printing system 110 comprises an incoming conveyor 111, a rotary actuator assembly 130, a screen print chamber 102, and an outgoing conveyor 112. The incoming conveyor 111 may be configured to receive a substrate 250 from an input device, such as an input conveyor 113 (i.e., path "A" in Figure 6), and transfer the substrate 250 to a printing nest 131 coupled to the rotary actuator assembly 130. The outgoing conveyor 112 may be configured to receive a processed substrate 250 from a printing nest 131 coupled to the rotary actuator assembly 130 and transfer the substrate 250 to a substrate removal device, such as an exit conveyor 114 (i.e., path "E" in Figure 7). The input conveyor 113 and the exit conveyor 114 may be automated substrate handling devices that are part of a larger production line. For example, the input conveyor 113 and the exit conveyor 114 may be part of the Softline™ tool, of which the screen printing system 110 may be a module.

The rotary actuator assembly 130 may be rotated and angularly positioned about the "F" axis by a rotary actuator (not shown) and a system controller 101, such that the printing nests 131 may be selectively angularly positioned within the screen printing system 110 (e.g., paths "Dl" and "D2" in Figure 7). The rotary actuator assembly 130 may also have one or more supporting components to facilitate the control of the print nests 131 or other automated devices used to perform a substrate processing sequence in the screen printing system 110.

In one embodiment, the rotary actuator assembly 130 includes four printing nests 131, or substrate supports, that are each adapted to support a substrate 250 during the screen printing process performed within the screen print chamber 102. Figure 7 schematically illustrates the position of the rotary actuator assembly 130 in which one printing nest 131 is in position "1" to receive a substrate 250 from the incoming conveyor 111, another printing nest 131 is in position "2" within the screen print chamber 102 so that another substrate 250 can receive a screen printed pattern on a surface thereof, another printing nest 131 is in position "3" for transferring a processed substrate 250 to the outgoing conveyor 112, and another printing nest 131 is in position "4", which is an intermediate stage between position "1" and position "3".

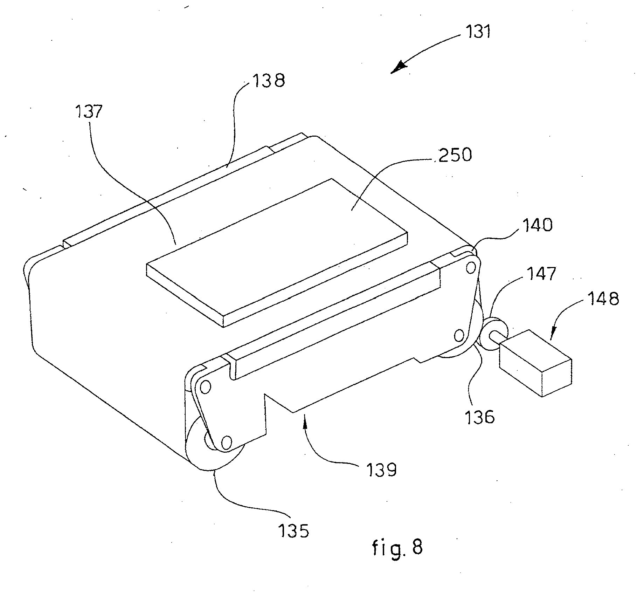

As illustrated in Figure 8, a printing nest 131 generally consist of a conveyor assembly 139 that has a feed spool 135, a take-up spool 136, rollers 140 and one or more actuators 148, which are coupled to the feed spool 135 and/or take-up spool 136, that are adapted to feed and retain a supporting material 137 positioned across a platen 138. The platen 138 generally has a substrate supporting surface on which the substrate 250 and supporting material 137 are positioned during the screen printing process performed in the screen print chamber 102. In one embodiment, the supporting material 137 is a porous material that allows a substrate 250, which is disposed on one side of the supporting material 137, to be retained on the platen 138 by a vacuum applied to the opposing side of the supporting material 137 by a conventional vacuum generating device (e.g., vacuum pump, vacuum ejector). In one embodiment, a vacuum is applied to vacuum ports (not shown) formed in the substrate supporting surface 138A of the platen 138 so that the substrate can be "chucked" to the substrate supporting surface 138A of the platen. In one embodiment, the supporting material 137 is a transpirable material that consists, for instance, of a transpirable paper of the type used for cigarettes or another analogous material, such as a plastic or textile material that performs the same function. In one example, the supporting material 137 is a cigarette paper that does not contain benzene lines.

In one configuration, the actuators 148 that is coupled to, or is adapted to engage with, the feed spool 135 and a take-up spool 136 so that the movement of a substrate 250 positioned on the supporting material 137 can be accurately controlled within the printing nest 131. In one embodiment, feed spool 135 and the take-up spool 136 are each adapted to receive opposing ends of a length of the supporting material 137. In one embodiment, the actuators 148 each contain one or more drive wheels 147 that are coupled to, or in contact with, the surface of the supporting material 137 positioned on the feed spool 135 and/or the take-up spool 136 to control the motion and position of the supporting material 137 across the platen 138.

In one embodiment, the screen printing system 110 may include an inspection assembly 200 adapted to inspect a substrate 250 located on the printing nest 131 in position "1". The inspection assembly 200 may include one or more cameras 121 positioned to inspect an incoming, or processed substrate 250, located on the printing nest 131 in position "1". In this configuration, the inspection assembly 200 includes at least one camera 121 (e.g., CCD camera) and other electronic components capable of inspecting and communicating the inspection results to the system controller 101 used to analyze the orientation and position of the substrate 250 on the printing nest 131. In another embodiment, the inspection assembly 200 comprises the optical inspection system 400, discussed above.

The screen print chamber 102 is adapted to deposit material in a desired pattern on the surface of a substrate 250 positioned on a printing nest 131 in position "2" during the screen printing process. In one embodiment, the screen print chamber 102 includes a plurality of actuators, for example, actuators 102A (e.g., stepper motors or servomotors) that are in communication with the system controller 101 and are used to adjust the position and/or angular orientation of a screen printing mask 102B (Figure 7) disposed within the screen print chamber 102 with respect to the substrate 250 being printed. In one embodiment, the screen printing mask 102B is a metal sheet or plate with a plurality of features 102C (Figure 7), such as holes, slots, or other apertures formed therethrough to define a pattern and placement of screen printed material (i.e., ink or paste) on a surface of a substrate 250. In general, the screen printed pattern that is to be deposited on the surface of a substrate 250 is aligned to the substrate 250 in an automated fashion by orienting the screen printing mask 102B in a desired position over the substrate surface using the actuators 102A and information received by the system controller 101 from the inspection assembly 200. In one embodiment, the screen print chamber 102 is adapted to deposit a metal containing or dielectric containing material on a solar cell substrate having a width between about 125 mm and 156 mm and a length between about 70 mm and 156 mm. In one embodiment, the screen print chamber 102 is adapted to deposit a metal containing paste on the surface of the substrate to form the metal contact structure on a surface of a substrate.

The system controller 101 facilitates the control and automation of the overall screen printing system 110 and may include a central processing unit (CPU) (not shown), memory (not shown), and support circuits (or I/O) (not shown). The CPU may be one of any form of computer processors that are used in industrial settings for controlling various chamber processes and hardware (e.g., conveyors, optical inspection assemblies, motors, fluid delivery hardware, etc.) and monitor the system and chamber processes (e.g., substrate position, process time, detector signal, etc.). The memory is connected to the CPU, and may be one or more of a readily available memory, such as random access memory (RAM), read only memory (ROM), floppy disk, hard disk, or any other form of digital storage, local or remote. Software instructions and data can be coded and stored within the memory for instructing the CPU. The support circuits are also connected to the CPU for supporting the processor in a conventional manner. The support circuits may include cache, power supplies, clock circuits, input/output circuitry, subsystems, and the like. A program (or computer instructions) readable by the system controller 101 determines which tasks are performable on a substrate. Preferably, the program is software readable by the system controller 101, which includes code to generate and store at least substrate positional information, the sequence of movement of the various controlled components, substrate optical inspection system information, and any combination thereof. In one embodiment of the present invention, the system controller 101 includes pattern recognition software to resolve the positions of heavily doped regions 241 and/or alignment marks.

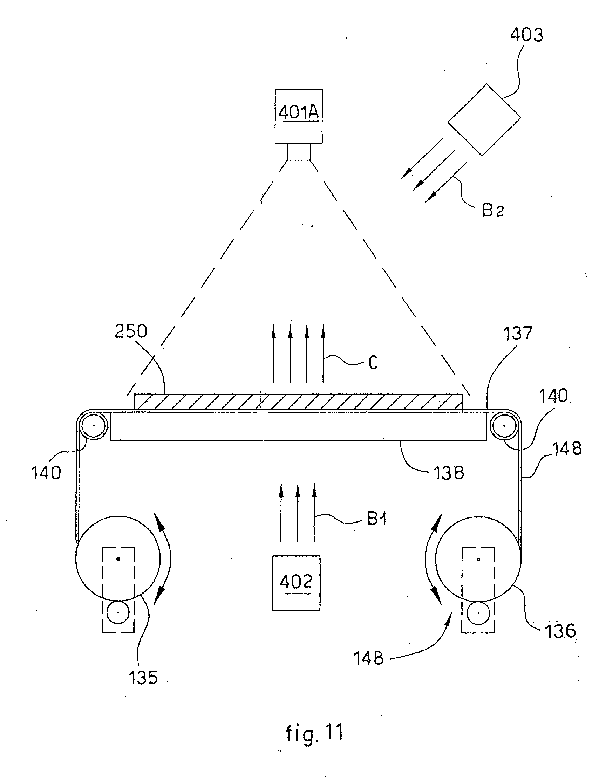

In an effort to directly determine the alignment and orientation of the heavily doped regions 241 formed on the substrate surface 251 prior to forming a patterned conductive layer thereon, the system controller 101 may use of one or more optical inspection systems 400 to collect the desired data. Figure 11 illustrates one embodiment of the optical inspection system 400 that is incorporated into part of the printing nest 131 and optical inspection assembly 200. In one embodiment, the inspection assembly 200 comprises a camera 401A, and the printing nest 131 that comprises a conveyor assembly 139, a supporting material 137, a platen 138, and a radiation source 402. In this configuration, the radiation source 402 is adapted to emit electromagnetic radiation "B1" to a surface 252 of a substrate 250 through the supporting material 137 and platen 138 on which the substrate 250 is "chucked." The emitted electromagnetic radiation "B1" then passes through portions of the substrate and follows path "C" to the camera 401A that is positioned to receive a portion of the emitted radiation. In general, the supporting material 137 and platen 138 are made from materials and have a thickness that will not significantly affect the signal-to-noise ratio of the electromagnetic radiation received and processed by the camera 401A and system controller 101. In one embodiment, the platen 138 is formed from an optically transparent material, such as sapphire, that will not significantly block the UV and IR wavelengths of light. As discussed above, in another embodiment, a radiation source 403 is configured to deliver electromagnetic radiation "B2" to a surface 251 of a substrate 250 that is positioned on the supporting material 137 and the platen 138 so that one or more of the emitted wavelengths will be absorbed or reflected by portions of the substrate 250 and delivered to the camera 401A following path "C".

Figure 9 is a schematic isometric view of one embodiment of the rotary actuator assembly 130 that illustrates an inspection assembly 200 that is positioned to inspect a surface 251 of a substrate 250 disposed on a printing nest 131.

Typically, the alignment of the pattern 230 on the surface 251 of the substrate 250 is dependent on the alignment of the pattern 230 to a feature of the substrate 250. In one example, the alignment of the pattern 230 is based on the alignment of the screen printing device to a feature on the substrate, such as edges 250A, 250B (Figure 9). The placement of a pattern 230 will have an expected position X and an expected angle orientation R with respect to edges 250A and an expected position Y with respect to an edge 250B of the substrate 250. The positional error of the pattern 230 on the surface 251 from the expected position (X, Y) and the expected angular orientation R on the surface 251 may be described as a positional offset (ΔX, ΔY) and an angular offset ΔR. Thus, the positional offset (ΔX, ΔY) is the error in the placement of the pattern 230 of heavily doped region(s) 241 relative to the edges 250A and 250B, and the angular offset ΔR is the error in the angular alignment of the pattern 230 of heavily doped region(s) 241 relative to the edge 250B of the substrate 250. The misplacement of the screen printed pattern 230 on the surface 251 of the substrate 250 can affect the ability of the formed device to perform correctly and thus affect the device yield of the system 100. However, minimizing positional errors becomes even more critical in applications where a screen printed layer is to be deposited on top of another formed pattern, such as disposing a conductive layer on the heavily doped region(s) 241.

To this purposes, in one embodiment, a camera 401A is positioned over the surface 251 of the substrate 250 so that a viewing area 122 of the camera 121 can inspect at least one region of the surface 251. The information received by the camera 401A is used to align the screen printing mask, and thus subsequently deposited material, to the heavily doped regions 241 by use of commands sent to the actuators 102A from the system controller 101. During normal process sequencing the heavily doped region 241 position information data is collected for each substrate 250 positioned on each printing nest 131 before it delivered to the screen print chamber 102. The inspection assembly 200 may also include a plurality of optical inspection systems 400 that are adapted to view different areas of a substrate 250 positioned on a printing nest 131 to help better resolve the pattern 230 formed on the substrate.

It is clear, however, that modifications and/or additions of steps or parts may be made to the method and system 100 as described heretofore, without departing from the field and scope of the present invention.

## Claims

1. Method for multi-layer printing on a support, like a wafer, a substrate or thin sheet made of silicon, comprising:
a plurality of printing steps (11, 21, 31), comprising a first (11) printing step and further subsequent printing steps (21, 31), made in corresponding printing stations (50, 60, 70) and
a plurality of alignment steps (13, 23), each one provided upstream of a corresponding of said further subsequent printing steps (21 , 31) following the first (11) printing step, wherein alignment devices (54, 64) effect the correct positioning of the support and/or the adjustment of said printing station (50, 60, 70) in order to carry out the subsequent printing step,
wherein said method comprises, downstream of each printing step (11, 21, 31) and upstream of each alignment step (13, 23), a control step (12, 22, 32) in which detection devices (52, 62, 72) detect the position of the layer printed on the support and/or the position of said support on the work plane, and at least a command and control unit (53, 63, 73, 120) compares at least one of said positions detected with predefined positions and/or with the positions detected in the previous control step, and
wherein the results of said comparison are used in subsequent alignment steps (13,
23),
**characterized in that**
the positions detected in each control step (12, 22, 32) are used by said command and control unit (53, 63, 73, 120) for a subsequent work cycle for multi-layer printing on a subsequent support in a respective alignment step prior to a respective one of each said control step.

2. Plant for multi-layer printing on a support, like a wafer, a substrate or thin sheet made of silicon, comprising
a plurality of printing stations (50, 60, 70) and
alignment devices, disposed upstream of each printing station subsequent to the first and able to position the support and/or the printing devices able to effect the subsequent printing step in order to print a subsequent layer,
wherein said plant comprises at least a command and control station (51, 61, 71) comprising detection devices (52, 62, 72) located downstream of each printing station (50, 60, 70) and able to detect the position of the layer printed on the support and/or the position of said support, and a command and control unit (53, 63, 73) able to compare at least one of said positions detected by the detection devices (52, 62, 72) relating to each printing station (50, 60, 70) with predefined positions and/or with the positions detected by the detection devices (52, 62, 72) relating to at least the previous printing station, and to transmit the results of said comparison to the alignment devices (54, 64) disposed upstream of the subsequent printing station
wherein said command and control unit (53, 63, 73, 120) is able to use the positions detected by said detection devices (52, 62, 72) for a subsequent work cycle for multi-layer printing on a subsequent support to command said alignment devices (54, 64) prior the detection actuated by said detection devices (52, 62, 72).

3. Plant as in claim 2, **characterized in that** it comprises a plurality of command and control units (53, 63, 73), each corresponding to a printing station (50, 60, 70) and connected to the alignment devices disposed upstream of said printing station, to the alignment devices disposed upstream of the subsequent printing station, and to the command and control unit corresponding to the subsequent printing station.

4. Plant as in claim 2, **characterized in that** it comprises a single command and control unit (120) that receives the position data from the detection devices (52, 62, 72) of each printing station (50, 60, 70), compares them with each other and with predefined positions according to preset programs and transmits the control signals to the different alignment devices (52, 62, 72).

5. Plant as in claims 2 to 4, **characterized in that** it comprises a central control and processing unit (90) that receives the data processed by the at least one command and control station (51, 61, 71), memorizes them according to predefined data bases and processes them in the forms requested by the user.

## Patentansprüche

1. Verfahren zum mehrschichtigen Drucken auf einem Träger, wie beispielsweise einem Wafer, einem Substrat oder einer Silizium-Dünnschicht, umfassend:
mehrere Druckschritte (11, 21, 31), umfassend einen ersten (11) Druckschritt und weitere nachfolgende Druckschritte (21, 31), die in zugehörigen Druckstationen (50, 60, 70) vorgenommen werden, und
mehrere Ausrichtungsschritte (13, 23), von denen jeder stromaufwärts von einem entsprechenden der weiteren nachfolgenden Druckschritte (21, 31) nach dem ersten (11) Druckschritt bereitgestellt wird, wobei Ausrichtungsvorrichtungen (54, 64) die korrekte Positionierung des Trägers und/oder die Einstellung der Druckstation (50, 60, 70) bewirken, um den nachfolgenden Druckschritt durchzuführen,
wobei das Verfahren stromabwärts von jedem Druckschritt (11, 21, 31) und stromaufwärts von jedem Ausrichtungsschritt (13, 23), einen Kontrollschritt (12, 22, 32) umfasst, in dem Erfassungsvorrichtungen (52, 62, 72) die Position der auf dem Träger gedruckten Schicht und/oder die Position des Trägers auf der Arbeitsebene erfassen, und mindestens eine Steuer- und Kontrolleinheit (53, 63, 73, 120) mindestens eine der erfassten Positionen mit vordefinierten Positionen und/oder mit den Positionen vergleicht, die in dem vorausgehenden Kontrollschritt erfasst wurden, und
wobei die Ergebnisse des Vergleichs in den nachfolgenden Ausrichtungsschritten (13, 23) verwendet werden,
**dadurch gekennzeichnet, dass**
die in jedem Kontrollschritt (12, 22, 32) erfassten Positionen von der Steuer- und Kontrolleinheit (53, 63, 73, 120) für einen nachfolgenden Arbeitszyklus für mehrschichtiges Drucken auf einem nachfolgenden Träger in einem jeweiligen Ausrichtungsschritt vor einem der jeweiligen Kontrollschritte verwendet werden.

2. Anlage zum mehrschichtigen Drucken auf einem Träger, wie beispielsweise einem Wafer, einem Substrat oder einer Silizium-Dünnschicht, umfassend:
mehrere Druckstationen (50, 60, 70) und
Ausrichtungsvorrichtungen, die stromaufwärts von jeder Druckstation nach der ersten angeordnet sind und die den Träger und/oder die Druckvorrichtungen positionieren können, die den nachfolgenden Druckschritt ausführen können, um eine nachfolgende Schicht zu drucken,
wobei die Anlage mindestens eine Steuer- und Kontrolleinheit (51, 61, 71) umfasst, die Erfassungsvorrichtungen (52, 62, 72) umfasst, die stromabwärts von jeder Druckstation (50, 60, 70) angeordnet sind und die Position der Schicht, die auf den Träger gedruckt ist, und/oder die Position des Trägers erfassen können, und eine Steuer- und Kontrolleinheit (53, 63, 73), die mindestens eine der durch die Erfassungsvorrichtungen (52, 62, 72), die zu jeder Druckstation (50, 60, 70) gehören, erfassten Positionen mit vordefinierten Positionen und/oder mit den durch die Erfassungsvorrichtungen (52, 62, 72), die zu mindestens der vorausgehenden Druckstation gehören, erfassten Positionen vergleichen kann, und um die Ergebnisse des Vergleichs an die Ausrichtungsvorrichtungen (54, 64) zu übertragen, die stromaufwärts der nachfolgenden Druckstation angeordnet sind,
wobei die Steuer- und Kontrolleinheit (53, 63, 73, 120) die durch die Erfassungsvorrichtungen (52, 62, 72) erfassten Positionen für einen nachfolgenden Arbeitszyklus für mehrschichtiges Drucken auf einem nachfolgenden Träger verwenden kann, um die Ausrichtungsvorrichtungen (54, 64) vor der Erfassung, die durch die Erfassungsvorrichtungen (52, 62, 72) betätigt wird, zu steuern.

3. Anlage nach Anspruch 2, **dadurch gekennzeichnet, dass** sie mehrere Steuer- und Kontrolleinheiten (53, 63, 73) umfasst, die jeweils zu einer Druckstation (50, 60, 70) gehören, und mit den Ausrichtungsvorrichtungen, die stromaufwärts der Druckstation angeordnet sind, mit den Ausrichtungsvorrichtungen, die stromaufwärts der nachfolgenden Druckstation angeordnet sind, und mit der Steuer- und Kontrolleinheit, die zu der nachfolgenden Druckstation gehört, verbunden sind.

4. Anlage nach Anspruch 2, **dadurch gekennzeichnet, dass** sie eine einzige Steuer- und Kontrolleinheit (120) umfasst, die die Positionsdaten von den Erfassungsvorrichtungen (52, 62, 72) jeder Druckstation (50, 60, 70) empfängt, sie miteinander und mit vordefinierten Positionen gemäß den voreingestellten Programmen vergleicht und die Steuersignale an die verschiedenen Ausrichtungsvorrichtungen (52, 62, 72) überträgt.

5. Anlage nach den Ansprüchen 2 bis 4, **dadurch gekennzeichnet, dass** sie eine zentrale Steuer- und Verarbeitungseinheit (90) umfasst, die die von der mindestens einen Steuer- und Kontrollstation (51, 61, 71) verarbeiteten Daten empfängt, sie gemäß vordefinierten Datenbanken speichert und sie in der vom Nutzer angeforderten Form verarbeitet.

## Revendications

1. Procédé pour impression multicouche sur un support, tel qu'une plaquette, un substrat ou une feuille mince fait de silicium, comprenant :
une pluralité d'étapes d'impression (11, 21, 31), comprenant une première (11) étape d'impression et des étapes d'impression subséquentes supplémentaires (21, 31), réalisées dans des stations d'impression (50, 60, 70) correspondantes et
une pluralité d'étapes d'alignement (13, 23), chacune prévue en amont d'une étape correspondante parmi lesdites étapes d'impression subséquentes supplémentaires (21, 31) qui suivent la première (11) étape d'impression, dans lequel des dispositifs d'alignement (54, 64) effectuent le positionnement correct du support et/ou le réglage de ladite station d'impression (50, 60, 70) afin d'exécuter l'étape d'impression subséquente,
dans lequel ledit procédé comprend, en aval de chaque étape d'impression (11, 21, 31) et en amont de chaque étape d'alignement (13, 23), une étape de contrôle (12, 22, 32) dans laquelle des dispositifs de détection (52, 62, 72) détectent la position de la couche imprimée sur le support et/ou la position dudit support sur le plan de travail, et au moins une unité de commande et de contrôle (53, 63, 73, 120) compare au moins l'une desdites positions détectées avec des positions prédéfinies et/ou avec les positions détectées à l'étape de contrôle précédente, et
dans lequel les résultats de ladite comparaison sont utilisés dans des étapes d'alignement subséquentes (13, 23),
**caractérisé en ce que**
les positions détectées à chaque étape de contrôle (12, 22, 32) sont utilisées par ladite unité de commande et de contrôle (53, 63, 73, 120) pour un cycle de travail subséquent pour impression multicouche sur un support subséquent dans une étape d'alignement respective préalable à une étape respective de chaque dite étape de contrôle.

2. Installation pour impression multicouche sur un support, tel qu'une plaquette, un substrat ou une feuille mince fait de silicium, comprenant
une pluralité de stations d'impression (50, 60, 70) et
des dispositifs d'alignement, disposés en amont de chaque station d'impression subséquente à la première et pouvant positionner le support et/ou les dispositifs d'impression pouvant réaliser l'étape d'impression subséquente afin d'imprimer une couche subséquente,
dans laquelle ladite installation comprend au moins une station de commande et de contrôle (51, 61, 71) comprenant des dispositifs de détection (52, 62, 72) situés en aval de chaque station d'impression (50, 60, 70) et pouvant détecter la position de la couche imprimée sur le support et/ou la position dudit support, et une unité de commande et de contrôle (53, 63, 73) pouvant comparer au moins une desdites positions détectées par les dispositifs de détection (52, 62, 72) concernant chaque station d'impression (50, 60, 70) avec des positions prédéfinies et/ou avec les positions détectées par les dispositifs de détection (52, 62, 72) concernant au moins la station d'impression précédente, et de transmettre les résultats de ladite comparaison aux dispositifs d'alignement (54, 64) disposés en amont de la station d'impression subséquente
dans laquelle ladite unité de commande et de contrôle (53, 63, 73, 120) peut utiliser les positions détectées par lesdits dispositifs de détection (52, 62, 72) pour un cycle de travail subséquent pour impression multicouche sur un support subséquent pour commander lesdits dispositifs d'alignement (54, 64) avant la détection actionnée par lesdits dispositifs de détection (52, 62, 72).

3. Installation selon la revendication 2, **caractérisée en ce qu'**elle comprend une pluralité d'unités de commande et de contrôle (53, 63, 73), chacune correspondant à une station d'impression (50, 60, 70) et étant reliée aux dispositifs d'alignement disposés en amont de ladite station d'impression, aux dispositifs d'alignement disposés en amont de la station d'impression subséquente, et à l'unité de commande et de contrôle correspondant à la station d'impression subséquente.

4. Installation selon la revendication 2, **caractérisée en ce qu'**elle comprend une seule unité de commande et de contrôle (120) qui reçoit les données de position des dispositifs de détection (52, 62, 72) de chaque station d'impression (50, 60, 70), les compare les unes aux autres et avec des positions prédéfinies en fonction de programmes pré-établis et transmet les signaux de commande aux différents dispositifs d'alignement (52, 62, 72).

5. Installation selon les revendications 2 à 4, **caractérisée en ce qu'**elle comprend une unité centrale de commande et de traitement (90) qui reçoit les données traitées par la au moins une station de commande et de contrôle (51, 61, 71), les mémorise en fonction de bases de données prédéfinies et les traite sous les formes demandées par l'utilisateur.
